# EUROPEAN PATENT SPECIFICATION

(11) **EP 4 223 481 B1**
(45) Date of publication and mention of the grant of the patent: **07.08.2024**
(21) Application number: 22155509.7
(22) Date of filing: 07.02.2022
(51) Int. Cl.: B29C 45/16, B29C 45/14, H01R 13/52

(54) **AN ELECTRICAL EQUIPMENT HOUSING ELEMENT WITH AN INTEGRATED GASKET AND A METHOD OF MANUFACTURING OF SUCH AN ELECTRICAL EQUIPMENT HOUSING ELEMENT**
GEHÄUSEELEMENT FÜR EIN ELEKTRISCHES GERÄT MIT EINER INTEGRIERTEN DICHTUNG UND VERFAHREN ZUR HERSTELLUNG EINES SOLCHEN GEHÄUSEELEMENTS FÜR EIN ELEKTRISCHES GERÄT
ÉLÉMENT DE BOÎTIER POUR ÉQUIPEMENT ÉLECTRIQUE AYANT UN JOINT INTÉGRÉ ET PROCÉDÉ DE FABRICATION D'UN TEL ÉLÉMENT DE BOÎTIER POUR ÉQUIPEMENT ÉLECTRIQUE

(43) Date of publication of application: 09.08.2023
(73) Proprietor: ABB Schweiz AG, 5400 Baden (CH)
(72) Inventor: Rybak, Andrzej, 30-349 Kraków (PL); Bednarowski, Dariusz, 31-952 Kraków (PL); Siwek, Artur, 31-421 Kraków (PL)
(74) Representative: Wroblewski, Marcin Jan

(56) References cited:
- EP-A1- 0 552 040
- WO-A1-2010/086144
- DE-A1- 102004 031 314
- DE-A1- 19 743 134
- DE-A1- 19 848 246

## Description

### Technical field of the invention

The present invention relates to an electrical equipment housing element with an integrated gasket comprising a body of the electrical equipment housing element and an integrated gasket, in particular gasket with gas barrier properties. The invention relates also to a method of manufacturing of such electrical equipment housing elements.

### Background of the invention

In the state of the art, so called 2K injection molding is commonly used in order to create elements made of two different materials, for example hard thermoplastic part with well adhering soft thermoplastic. The 2K injection molding is also known as two-component injection molding or two-color molding.

The most common way of making sealing in gas insulated electrical devices is application of the O-rings made of vulcanized rubber, like EPDM. Such type of sealing is applied separately during device assembly and is used mainly in epoxy casted parts. Currently there is a trend to replace the epoxy resin to more sustainable thermoplastic materials, therefore it would be of interest to also switch from standard rubber sealing to thermoplastic one. In such case sealing system can be integrated with device during the same injection molding process by means of two-component - 2K - injection molding.

In case of the O-rings or other similar seals it is necessary to assemble the seal in a groove in appropriate part of the housing, for example on a body or on a lid of a box. It is not simple nor economic operation. The seal might be inserted and/or fixed within the groove in an incorrect way and thus the seal comes out of the groove. Therefore the tightness of the housing is much worse than expected. EP0792095A2 discloses a one-piece seal comprising protruding areas which overcomes this problem. The seal is produced in one manufacturing step at the same time as the appropriate part of the housing - a lid or a body. During manufacturing process, after the end of the moulding step, mobile element of a counterdie form creates a groove in the lid or in the body. The groove is a space which dimensions are corresponding to those of the seal. Into this space there is injected plastic material that forms the seal. The plastic material is normally softer than the material forming the lid or the body. The box is made of a thermoplastic material and the integrated seal is made of thermoplastic elastomer.

Besides EP1045174 discloses a gasket fitted to a frame which hermetically seals the joint surface between a cover body and a main body in lightweight electronic equipment. Process of production of such gasket is also disclosed. The gasket is designated to be used for example in hard disc equipment of a computer and its application completely keeps water and air away from the electronic equipment and thus it gives high tightness. The frame of the body comprises an outer frame body and an inner frame which are integrated with each other. The frame is made of a thermoplastic resin. The gasket is integrated with the outer frame body and inner frame body and comprises an elastic body. The gasket is made of a thermoplastic elastomer. Fixing the gasket to the lateral sides of the outer frame body and the inner frame body leads to integration of the gasket with inner frame body and outer frame body. The fixing process covers integration by fusion adhesion or integration by two-color molding method. The frame of the body might be made of synthetic resin, especially thermoplastic resin and the elastic body constituting the gasket might be of thermoplastic elastomer.

EP3310547B1 discloses a plastic housing with housing body made of first plastic material, duroplastic or thermoplastic, which is modified with heat-conductive fillers. Particularly the housing can be made of a thermoplastic material reinforced with the same thermally conductive fillers, such as polyamide or polyphenylene sulfide. The housing body has got at least one sealing element which is made of second plastic material, for example it might be made of thermoplastic elastomer. The housing body and the sealing element are connected. The sealing element is bonded and/or injected onto the housing body in a formfitting manner. The housing has also at least one covering cap, which is placed on the housing body at an end portion. The sealing element seals a connection between the housing body and the covering cap. Patent EP3310547B1 discloses also method of a production of the plastic housing by means of injection-moulding devices. Method of production comprises step of injection of first plastic material into a first cavity of an injection mould in order to produce housing body and step of withdrawal of hydraulic cores in the injection mould in order to configure a second cavity in the injection mould in order to produce the sealing element. Into this second cavity resilient plastic is injected by means of a second injection unit, which configures the sealing element. Therefore, the sealing element is bonded to the housing body. In the subsequent step the covering cap is placed on the housing body.

DE19743134 A1 discloses the manufacturing of composite parts, such as housings, produced my hard/soft multi-component injection moulding.

What is more, EP0245975B1 discloses an electrical connector. This document discloses also a method of making a connector housing by dual injection molding. The connector comprises a plug and receptacle housing members, each member having a rigid and a flexible portion secured to one end thereof. The connector contains at least one electrical terminal receiving passageway extending through the rigid and flexible portions. The flexible portions of the passageways accommodate and engages a variety of wire sizes terminated to electrical terminals. Electrical terminals are received and disposed in the passageways of the assembled connector. The connector has got a sealing part made during dual injection molding. Manufacturing process of electrical connector covers introducing a first plastic material having flexible or rigid characteristics into a first section of a connector housing forming area in a mold and preventing the first plastic material from entering a second section of the connector housing forming area of the mold. In the next stage a second plastic material is introduced, which has rigid or flexible characteristics opposite to the first plastic material into the second section of the connector housing forming area so that the connector housing so that the connector housing is formed and chemical bonding takes place at an interface between the first and second plastic materials causing them to adhere. After that, additional plastic material having flexible characteristics is introduced into the section of the connector housing forming area of the mold containing the plastic material having rigid characteristics so that at least one flexible sealing connector member is formed at the front end of the rigid section and chemical bonding takes place at an interface between the flexible and rigid materials causing them to adhere. In this solution thermoplastics, thermoplastic elastomers and thermosetting rubbers might be used and in order to increase chemical affinity between these materials. It is preferred when a similarly based polymer is used as a first and second plastic material.

Whereas WO2010086144A1 discloses a seal produced by injection molding according to the sandwich technology or with usage of by multi-component injection molding. The seal comprises a core made of a hard plastic and a skin made of a comparatively soft plastic. At lase one core end passes through the skin. This core end passes to the outside to form an opening or passes in a narrowing manner up to the edge of the skin without forming an opening. What is more, in the interior of the core a dimensionally stable carrier might be arranged. During manufacturing process materials of the seal are injected one after the other to melt into the cavity of injection mold. In first step, the skin component is injected, which extends progressively in the cavity. In the next step, the core component is injected into the cavity. The core component then progresses in the cavity, at least partially surrounded by the skin component. Such seal, produced by presented method, needs to be assembled into parts where a sealing should be realized. This seal is not connected nor bonded with sealed components.

### PROBLEM

Current sealing systems in electrical devices are mainly based on application of vulcanized rubber in the form of O-ring. Application of such sealing requires to create a groove in the flange of device. The operator needs to take care of proper operating with the O-ring in order to avoid it from becoming dirty, what is difficult in case of large sealing system. Additionally, the quality of the groove surface should possess the proper roughness, so suitable machining and polishing operations might be necessary. There are also known methods of manufacturing of devices with integrated gaskets. Such methods eliminate assembly operations. However already known gaskets do not have required properties, for example as far as gas tightness is concerned. Therefore an object of the invention is to provide a sealing with improved gas barrier.

### The essence of the invention

The invention presents the means to improve sealing system in the electrical device. In particular, the invention presents how to increase the gas tightness by application of 2K integrated gasket with embedded gas barrier made by means of sandwich molding. The invention concerns an electrical equipment housing element with an integrated gasket comprising a body of the electrical equipment housing element and an integrated gasket. The essence of the invention is that the gasket is a core-shell gasket having a core formed of thermoplastic elastomer and the shell formed of a thermoplastic polymer having high gas barrier properties, wherein the body of the electrical equipment housing element and the shell of the gasket are chemically or chemically-mechanically bonded in 2K injection molding process.

In case when a main body of the electrical device is manufactured from thermoplastic material by means of injection molding, it is beneficial to fabricate in the same process the integrated sealing by means of 2K injection molding. Additionally, the fabricated thermoplastic gasket has an advanced core-shell barrier structure made by means of a sandwich molding process, with a shell material possessing high gas barrier properties. The proposed solution allows to obtain more reliable sealing system manufactured simultaneously during injection molding of electrical device housing.

It is also beneficial when the core of the gasket is formed of thermoplastic elastomer having a low compression set values equal to or less than 10% at temperature of 23°C, and equal to or less than 30% at temperature of 70°C.

Low compression set is understood as an amount of permanent deformation that a product sustains when put under pressure or force according to ISO 815 and ASTM D395 standard.

It is advantageous if the shell of the gasket is formed of an ethylene-vinyl alcohol copolymer or a thermoplastic elastomer with a low carbon dioxide gas permeability values equal to or less than 65 Barrer at temperature of 25°C and equal to or less than 250 Barrer at temperature of 75°C.

Barrer is understood as a non-SI unit of gas permeability. It gives information concerning measure of the rate of fluid flow passing through an area of material with a thickness driven by a given pressure.

Another aspect of invention concerns method of manufacturing an electrical equipment housing element with integrated gasket. 2K injection molding process comprising the steps of:
a) forming a body of the electrical equipment housing element,
b) forming the gasket.

The essence of the method is that during step b) a core-shell gasket is formed in sandwich injection molding process wherein a core of the gasket is formed of thermoplastic elastomer whereas the shell of the gasket is formed of material of polymers having high gas barrier properties.

Also, in case of method of manufacturing, it is also preferable when the core of the gasket is formed of thermoplastic elastomer having a low compression set with the values equal to or less than 10% at temperature of 23°C and equal to or less than 30% at temperature of 70°C.

It is advantageous when the shell of the gasket is formed of an ethylene-vinyl alcohol copolymer or thermoplastic elastomer with a low carbon dioxide gas permeability values equal to or less than 65 Barrer at temperature of 25°C and equal to or less than 250 Barrer at temperature of 75°C.

It is also good if the body of the electrical equipment housing element is molded from high strength and dielectric thermoplastic material, or thermoplastic composite material.

Gaskets according to the invention provide improved sealing performance. Gaskets have shell formed of a thermoplastic polymer having high gas barrier properties and provide gas tightness and possibility to use electrical devices regardless of external conditions, especially when they are exposed to environment or when should provide gas tightness. What is more, increased gas tightness protects internal space of electrical equipment against leakage to the outside and pressure loss of dielectric protection gases placed inside the housing.

### Advantages of the invention

Main advantages of that invention are:
- possibility to make complex shape of sealing comparing to standard O-rings, which meets expectations and requirements of novel design concepts of electrical devices as well as enables product diversification due to limitation of dependance on one technology,
- sealing integration with device, which eliminates problem with groove surface quality, which is important in case of usage of O-rings,
- easier assembling of device because the gasket is already integrated within the body of the electrical equipment, which saves time during production process as well as gives high reliability and safety of the sealing; during assembly process the sealing is already at right place, so it eliminates leaks resulting from incorrect assembly of O-rings,
- and what is more there are less components as well as less parts to store and handle, because there is no necessity of storing and handling for example of gaskets as individual parts.

The invention may, for example, be applied in such electrical equipment as bushings, cable sockets, busbar sockets.

### Description of the drawings

Embodiments of the subject matter of the invention have been presented in the drawing, where:

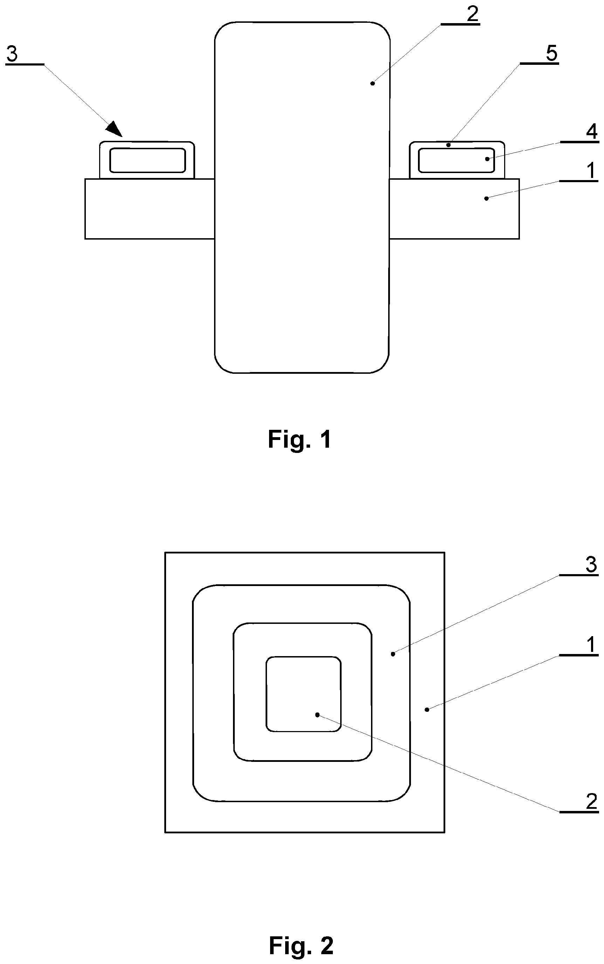

- Fig. 1: presents a schematic side view of the electrical device with applied integrated core-shell sealing,
- Fig. 2: presents a schematic top view of the electrical device with applied integrated core-shell sealing,

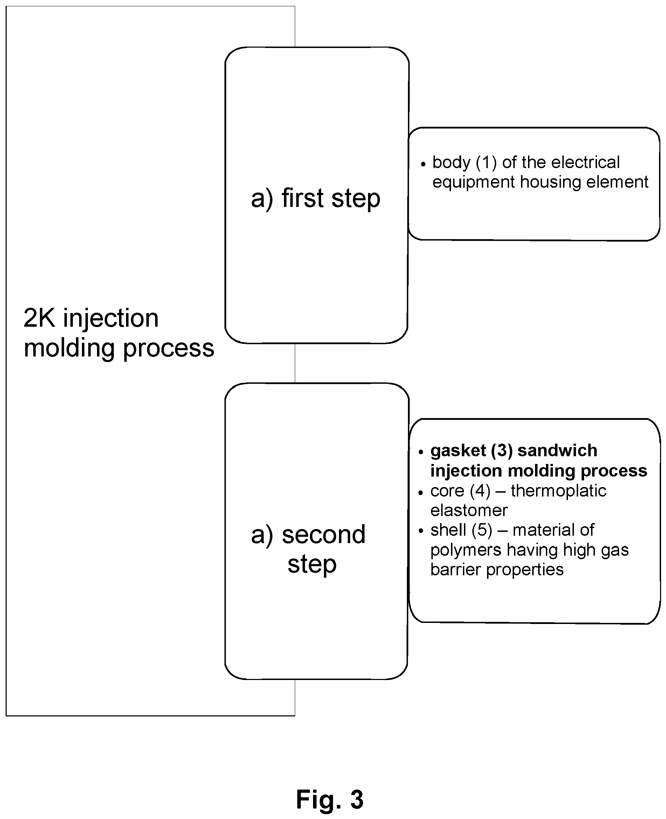

- Fig. 3: presents schematically an implementation of the method according to the invention.

### Detailed description of the invention

An electrical equipment housing element with an integrated gasket comprises a body 1 of the electrical equipment housing, a conductor 2 being the electrical equipment and the integrated gasket 3. By the gasket 3 integrated with the body 1 of the electrical equipment housing it is understood that the gasket 3 is inseparably, chemically or chemically-mechanically bonded with the housing body 1. The housing body 1 of the electrical equipment housing is integrated with the gasket 3 in 2K injection molding process, during which chemical or chemical-mechanical bonding between the housing and the gasket takes place.

Gasket 3 is a core shell gasket. It has a core 4 formed of thermoplastic elastomer and the shell 5 formed of thermoplastic polymer having high gas barrier properties. Gasket 3 ensures gas tightness of the electrical equipment housing.

In embodiments the core 4 of the gasket 3 is formed of thermoplastic elastomer having a low compression set according to standard ISO 815 and ASTM D395 with the values equal to or less than 10% at temperature of 23°C and equal to or less than 30% at temperature of 70°C. Low compression set is defined as an amount of permanent deformation that a product sustains when put under pressure or force. Low compression set means that after removal of pressure or force the product has relatively small deformations.

In further embodiments the shell 5 of the gasket 3 is formed of an ethylene-vinyl alcohol copolymer or thermoplastic elastomer with low gas permeability, which protects internal space of electrical equipment against leakage to the outside and pressure loss of dielectric protection gases placed inside the housing. The shell 5 is characterized by a low carbon dioxide gas permeability values equal to or less than 65 Barrer at temperature of 25°C and equal to or less than 250 Barrer at temperature of 75°C.

In each embodiment the body 1 of the electrical equipment housing element is molded from high strength and dielectric thermoplastic material, or thermoplastic composite material, which possess the adequate dielectric properties. It provides appropriate proprieties of the housing, which might be used in different conditions as well as protects users or other people against damaged electrical equipment.

The above presented electrical equipment housing element with integrated gasket 3 is manufactured in one 2K injection molding process.

The manufacturing process has following steps of 2K injection molding process:
a) first step of forming the body1 of the electrical equipment housing element,
b) second step of forming the gasket 3,
wherein during second step b) the core-shell gasket 3 is formed in sandwich injection molding process wherein the core 4 of the gasket 3 is formed of thermoplastic elastomer whereas the shell 5 of the gasket 3 is formed of polymers having high gas barrier properties.

Therefore the manufacturing process covers also sandwich injection molding process which is defined in a such way, that two or more polymers are injected one after the another through the same gate in one or more cavities. As a rule two steps could be distinguished, first step of injecting first material and second step of injecting second material, so both materials are injected into the mould one after another. Because of the fountain flow of the polymer melts, a characteristic sandwich structure with a shell and a core layer is formed. A thin boundary layer of the first injected material solidifies, while the core remains plastic. The second subsequently injected material fills the core and the first material takes over the function of the skin. The process can be used for all thermoplastic materials.

The process of forming the body 1 of the electrical equipment housing element is generally used to manufacture main body 1 from high strength thermoplastic material, or thermoplastic composite material possessing the dielectric properties, which are necessary for housings which might be used as external housings. The process of forming the body 1 covers first step of 2K injection molding. In this step electrical equipment is inserted to the mould and these internal parts are over-moulded with high strength thermoplastic material, or thermoplastic composite material.

As already mentioned, the second step is used to form sealing system with high gas barrier properties. It also requires appropriate selection of sealing material which have to allow for good integration of sealing with the housing with electrical device. Factors like good adhesion or modification of the interface between the body 1 and the gasket 3 by mechanical interlocking, should be considered.

The process of forming the body 1 of the electrical equipment housing element covers also final step of 2K injection molding, during which final product with integrated gasket 3 is demolded.

In the manufacturing process the core 4 material can be selected from the group of thermoplastic elastomers having the low compression set values equal to or less than 10% at temperature of 23°C and equal to or less than 30% at temperature of 70°C. A material for the shell 5 of the gasket 3 can be chosen from the polymers possessing high gas barrier properties, for example ethylene-vinyl alcohol copolymer or thermoplastic elastomers with low carbon dioxide gas permeability, so with values equal to or less than 65 Barrer at temperature of 25°C and equal to or less than 250 Barrer at temperature of 75°C. The applied core material will maintain proper mechanical functionality of the gasket 3, while the shell material will ensure gas tightness of the electrical device.

Additionally, to already mentioned materials, in further embodiments following materials might be used:
- polyamide for the body 1 of the electrical equipment housing, thermoplastic polyamides for the core 4 of the gasket 3 and thermoplastic vulcanizates for the shell 5 of the gasket 3;
- polyphthalamide for the body 1 of the electrical equipment housing, thermoplastic copolyester for the core 4 of the gasket 3 and styrenic block copolymers for the shell 5 of the gasket 3;
- polyphthalamide for the body 1 of the electrical equipment housing, thermoplastic polyurethanes for the core 4 of the gasket 3 and styrenic block copolymers for the shell 5 of the gasket 3.

As a rule, the thermoplastic elastomers for the core 4 and polymers for the shell 5 can be selected from the following types of materials:
- styrenic block copolymers,
- thermoplastic polyolefinelastomers,
- thermoplastic vulcanizates,
- thermoplastic polyurethanes,
- thermoplastic copolyester,
- thermoplastic polyamides,
- not-classified thermoplastic elastomers.

Besides it is useful when the body 1 of the electrical equipment housing element is molded from high strength and dielectric thermoplastic material, or thermoplastic composite material, including but not limited to acetal and ketal based polymers and copolymers, polyesters, with polyethylene terephthalate and polybutylene terephthalate; polycarbonate, polystyrene, polyether sulfone, polyphenylene sulfone, polysulfone, and polytetrafluoroethylene. Also, other polymers can also be implemented, including but not limited to polyvinyl chloride, polyethylene, polypropylene, polyetherimide, polyphenylene sulfide, polyether ether ketone, polyphthalamide, polyoxymethylene, phenolformaldehyde, unsatured polyester, polyurethane, polyimide, polyamide, polyvinyl alcohol, polyvinylidene chloride, polyacrylonitrile and polyalkylene paraoxybenzoate. In some embodiments, the composite can include a variety of types of fibers, including but not limited to glass fiber, basalt fiber, wool, silk, cotton, rayon, cellulose, cellulose acetate, flax, ramie, jute and aramid fibers. In some embodiments, additives can be used to improve the qualities of the materials, including but not limited to the mechanical and thermal stability, chemical resistance, insulation property and flammability. The additives can include, but are not limited to, ceramics, alumina, calcium silicate, flame retardants and clays.

What is more, in successive embodiments, the materials used to produce the body 1 of the electrical equipment housing with the integrated gasket 3 can be characterized by a hardness relationship between materials of the body 1 and materials of the gasket 3. The hardness of the gasket 3 is measured according to ISO 48 and ASTM D2240-00 standard for test method for rubber property, also called as durometer hardness. The hardness of the body 1 of the electrical equipment housing is measured according to ISO 2039-2 standard, which specifies a method for determining the indentation hardness of plastics by means of the Rockwell hardness tester using the Rockwell M, L and R hardness scales.

In this embodiment materials, which have been used to produce the body 1 of the electrical equipment housing and gasket 3 with the core 4 and with the shell 5, have following hardness relationship between them:
- the hardness of the shell 5 of the gasket 3 is in the range from 10 Shore A to 90 Shore A,
- the hardness of the core 4 of the gasket 3 is in the range from 65 Shore A to 85 Shore D,
- the hardness of the body 1 is in the range from 70 Rockwell R to 150 Rockwell R.

Following relation also applies: the hardness of the shell 5 of the gasket 3 is not greater than that of the core 4 of the gasket 3, while the hardness of the shell 5 and of core 3 is not greater than the hardness of the body 1.

Moreover, the use of low-hardness materials as the shell 5 allows for better filling of unevenness on the interface between the gasket 3 and the sealed element - body 1.

## Claims

1. An electrical equipment housing element with an integrated gasket comprising a body (1) of the electrical equipment housing element and an integrated gasket (3),
**characterized in that**:
- the gasket (3) is a core-shell gasket having a core (4) formed of thermoplastic elastomer and the shell (5) formed of a thermoplastic polymer having high gas barrier properties,
- wherein the body (1) of the electrical equipment housing element and the shell (5) of the gasket (3) are chemically or chemically-mechanically bonded in 2K injection molding process.

2. The electrical equipment housing element according to claim 1 **characterized in that** the core (4) of the gasket (3) is formed of thermoplastic elastomer having a low compression set with the values equal to or less than 10% at temperature of 23°C and equal to or less than 30% at temperature of 70°C.

3. The electrical equipment housing element according to claim 1 or 2 **characterized in that** the shell (5) of the gasket (3) is formed of an ethylene-vinyl alcohol copolymer or thermoplastic elastomer with low carbon dioxide gas permeability values equal to or less than 65 Barrer at temperature of 25°C and equal to or less than 250 Barrer at temperature of 75°C.

4. The electrical equipment housing element according to claim to any of the claims 1 to 3 **characterized in that** the body (1) of the electrical equipment housing element is molded from high strength and dielectric polymer material, or polymer composite material.

5. Method of manufacturing an electrical equipment housing element with integrated gasket according to any of the claims 1 to 4 in one 2K injection molding process comprising the steps of:
a) forming a body (1) of the electrical equipment housing element,
b) forming the gasket (3),
**characterized in that**
during step b) a core-shell gasket (3) is formed in sandwich injection molding process wherein a core (4) of the gasket (3) is formed of thermoplastic elastomer, whereas the shell (5) of the gasket (3) is formed of polymers having high gas barrier properties.

6. Method according to claim 5 **characterized in that** the core (4) of the gasket (3) is formed of thermoplastic elastomer having a low compression set with the values equal to or less than 10% at temperature of 23°C and equal to or less than 30% at temperature of 70°C.

7. Method according to claim 5 or 6 **characterized in that** the shell (5) of the gasket (3) is formed of an ethylene-vinyl alcohol copolymer or thermoplastic elastomer with low carbon dioxide gas permeability values equal to or less than 65 Barrer at temperature of 25°C and equal to or less than 250 Barrer at temperature of 75°C.

8. Method according to any of the claims 5 to 7 **characterized in that** the body (1) of the electrical equipment housing element is molded from high strength and dielectric polymer material, or polymer composite material.

## Patentansprüche

1. Ein Gehäuseelement für eine elektrische Ausrüstung mit einer integrierten Dichtung, das einen Körper (1) des Gehäuseelements für eine elektrische Ausrüstung und eine integrierte Dichtung (3) umfasst,
**dadurch gekennzeichnet, dass**:
- die Dichtung (3) eine Kern-Schale-Dichtung mit einem Kern (4) aus einem thermoplastischen Elastomer und einer Schale (5) aus einem thermoplastischen Polymer mit hohen Gasbarriereeigenschaften ist,
- wobei der Körper (1) des Gehäuseelements für eine elektrische Ausrüstung und die Schale (5) der Dichtung (3) im 2K-Spritzgießverfahren chemisch oder chemischmechanisch verbunden sind.

2. Das Gehäuseelement für eine elektrische Ausrüstung nach Anspruch 1, **dadurch gekennzeichnet, dass** der Kern (4) der Dichtung (3) aus einem thermoplastischen Elastomer mit einem niedrigen Druckverformungsrest gebildet ist, dessen Werte bei einer Temperatur von 23°C gleich oder kleiner als 10% und bei einer Temperatur von 70°C gleich oder kleiner als 30% sind.

3. Das Gehäuseelement für eine elektrische Ausrüstung nach Anspruch 1 oder 2, **dadurch gekennzeichnet, dass** die Schale (5) der Dichtung (3) aus einem Ethylen-Vinylalkohol-Copolymer oder einem thermoplastischen Elastomer mit niedrigen Kohlendioxid-Gasdurchlässigkeitswerten von gleich oder weniger als 65 Barrer bei einer Temperatur von 25°C und gleich oder weniger als 250 Barrer bei einer Temperatur von 75°C gebildet ist.

4. Das Gehäuseelement für eine elektrische Ausrüstung nach einem der Ansprüche 1 bis 3, **dadurch gekennzeichnet, dass** der Körper (1) des Gehäuseelements für eine elektrische Ausrüstung aus einem hochfesten und dielektrischen Polymermaterial oder einem Polymerverbundmaterial geformt ist.

5. Verfahren zur Herstellung eines Gehäuseelements für eine elektrische Ausrüstung mit integrierter Dichtung nach einem der Ansprüche 1 bis 4 in einem 2K-Spritzgießverfahren, das die folgenden Schritte umfasst:
a) Formen eines Körpers (1) des Gehäuseelements für eine elektrische Ausrüstung,
b) Formen der Dichtung (3),
**dadurch gekennzeichnet, dass**
während des Schritts b) eine Kern-Schale-Dichtung (3) in einem Sandwich-Spritzgießverfahren gebildet wird, wobei ein Kern (4) der Dichtung (3) aus einem thermoplastischen Elastomer gebildet wird, während die Schale (5) der Dichtung (3) aus Polymeren mit hohen Gasbarriereeigenschaften gebildet wird.

6. Verfahren nach Anspruch 5, **dadurch gekennzeichnet, dass** der Kern (4) der Dichtung (3) aus einem thermoplastischen Elastomer mit einem niedrigen Druckverformungsrest gebildet ist, dessen Werte bei einer Temperatur von 23°C gleich oder kleiner als 10% und bei einer Temperatur von 70°C gleich oder kleiner als 30% sind.

7. Verfahren nach Anspruch 5 oder 6, **dadurch gekennzeichnet, dass** die Schale (5) der Dichtung (3) aus einem Ethylen-Vinylalkohol-Copolymer oder einem thermoplastischen Elastomer mit niedrigen Kohlendioxid-Gasdurchlässigkeitswerten von gleich oder weniger als 65 Barrer bei einer Temperatur von 25°C und gleich oder weniger als 250 Barrer bei einer Temperatur von 75°C gebildet ist.

8. Verfahren nach einem der Ansprüche 5 bis 7, **dadurch gekennzeichnet, dass** der Körper (1) des Gehäuseelements für eine elektrische Ausrüstung aus einem hochfesten und dielektrischen Polymermaterial oder einem Polymerverbundmaterial geformt ist.

## Revendications

1. Un élément de boîtier d'équipement électrique avec un joint intégré comprenant un corps (1) de l'élément de boîtier d'équipement électrique et un joint intégré (3),
**caractérisé en ce que** :
- le joint (3) est un joint noyau-coquille dont le noyau (4) est formé d'un élastomère thermoplastique et la coquille (5) est formée d'un polymère thermoplastique ayant des propriétés de barrière aux gaz élevées,
- dans lequel le corps (1) de l'élément de boîtier d'équipement électrique et la coquille (5) du joint (3) sont chimiquement ou chimico-mécaniquement liés dans le processus de moulage par injection 2K.

2. L'élément de boîtier d'équipement électrique selon la revendication 1, **caractérisé en ce que** le noyau (4) du joint (3) est formé d'un élastomère thermoplastique ayant une faible déformation rémanente à la compression avec des valeurs égales ou inférieures à 10% à une température de 23°C et égales ou inférieures à 30% à une température de 70°C.

3. L'élément de boîtier d'équipement électrique selon la revendication 1 ou 2, **caractérisé en ce que** la coquille (5) du joint (3) est formée d'un copolymère éthylène-alcool vinylique ou d'un élastomère thermoplastique avec des valeurs de perméabilité au gaz de dioxyde de carbone faibles égales ou inférieures à 65 Barrer à une température de 25°C et égales ou inférieures à 250 Barrer à une température de 75°C.

4. L'élément de boîtier d'équipement électrique selon l'une des revendications 1 à 3, **caractérisé en ce que** le corps (1) de l'élément de boîtier d'équipement électrique est moulé à partir d'un matériau polymère à haute résistance et diélectrique, ou d'un matériau composite polymère.

5. Procédé de fabrication d'un élément de boîtier d'équipement électrique avec joint intégré selon l'une des revendications 1 à 4 dans un processus de moulage par injection 2K comprenant les étapes suivantes :
a) formage d'un corps (1) de l'élément de boîtier d'équipement électrique,
b) formage du joint (3),
**caractérisé en ce que**
au cours de l'étape b), un joint noyau-coquille (3) est formé par un procédé de moulage par injection en sandwich, dans lequel le noyau (4) du joint (3) est formé d'un élastomère thermoplastique, tandis que la coquille (5) du joint (3) est formée de polymères ayant des propriétés de barrière aux gaz élevées.

6. Procédé selon la revendication 5, **caractérisé en ce que** le noyau (4) du joint (3) est formée d'un élastomère thermoplastique ayant une faible déformation rémanente à la compression avec des valeurs égales ou inférieures à 10% à une température de 23°C et égales ou inférieures à 30% à une température de 70°C.

7. Procédé selon la revendication 5 ou 6, **caractérisé en ce que** la coquille (5) du joint (3) est formée d'un copolymère éthylène-alcool vinylique ou d'un élastomère thermoplastique avec des valeurs de perméabilité au gaz de dioxyde de carbone faibles égales ou inférieures à 65 Barrer à une température de 25°C et égales ou inférieures à 250 Barrer à une température de 75°C.

8. Procédé selon l'une des revendications 5 à 7, **caractérisé en ce que** le corps (1) de l'élément de boîtier d'équipement électrique est moulé à partir d'un matériau polymère à haute résistance et diélectrique, ou d'un matériau composite polymère.
